# EUROPEAN PATENT SPECIFICATION

(11) **EP 4 693 232 B1**
(45) Date of publication and mention of the grant of the patent: **30.09.2026**
(21) Application number: 24193578.2
(22) Date of filing: 08.08.2024
(51) Int. Cl.: G07C 1/22, G07C 1/02, G07C 1/24, G06K 7/10

(54) **TRANSPONDER FOR DETERMINING A PASSING TIME**
TRANSPONDER ZUR BESTIMMUNG EINER DURCHLAUFZEIT
TRANSPONDEUR POUR DÉTERMINER UN TEMPS DE PASSAGE

(43) Date of publication of application: 11.02.2026
(73) Proprietor: race result AG, 76327 Pfinztal (DE)
(72) Inventor: Klohr, Nikias, 76297 Stutensee (DE)
(74) Representative: Durm Patentanwälte PartG mbB

(56) References cited:
- EP-B1- 2 453 415
- US-A1- 2004 160 355
- US-A1- 2012 087 421
- US-A1- 2016 279 500
- US-A1- 2018 122 159

## Description

The present invention relates to a transponder for determining a passing time upon passing an RFID loop antenna. The present invention further relates to a system and a method for determining a passing time of a transponder upon passing an RFID loop antenna, as well as to a computer program.

In the fields of timing and tracking, particularly timing at sports events, for example running events, marathons, bicycle races, skiing races, car races, horse races or others, timing of participants' start, finish, and split times plays an important role. In prevailing timing and tracking systems, a person, a vehicle, an animal or also an object, whose time is to be measured, usually carries or has attached a radio element (sports timing transponder, in particular an active or passive RFID tag) for non-contact, automated timing. Runners, for instance, may carry radio elements that are attached to shoe laces or to a bib number for being pinned to the participant's shirt or pants.

At a sports event, measuring points are provided at the start, finish and split time positions along a track to detect the presence of the radio element and determine a passing time, i.e. a moment in time at which the radio element passes the measuring point. For this purpose, a measuring point usually comprises a receiver with a corresponding antenna and data processing means to process the received data. Usually, the determined passing times for the participants are then communicated to a central evaluation point for access by the organizers of the event and the participants. Other applications, e.g. in the field of object tracking, can pose comparable problems.

In this context, a transponder, and in particular a sports timing transponder, designates a radio element that is able to transmit and receive radio signals. As used herein, a transponder particularly refers to an active RFID tag with an included battery and processing capabilities, as opposed to a passive RFID tag that has no integrated energy source and can therefore only provide very limited processing capabilities. For such an active RFID tag, usually an inductive loop (also referred to RFID loop antenna or, short, the loop) is detected by the tag and a passing time is calculated based on multiple detections.

One problem in this respect relates to the actual determination of the passing time i.e. the point in time, at which the transponder passes (or is positioned at a minimum distance to) the loop. Current transponders in this field usually include three inductive coils for detecting the inductive field of the RFID loop antenna and providing a three-dimensional field strength detection. The RFID loop antenna repetitively transmits an activation signal that is detected by the inductive coils in the transponder. In most current systems the passing time is determined as the point in time at which the highest field strength is detected. Thereby, the passing time can be indicated on a time basis of the transponder, the timing system, or also on an absolute time basis corresponding to a real time or an external time (as e.g. obtained from a timing authority).

In this respect US 6,864,829 B2 relates to a system for determining a position of a moving transponder. The system comprises a signal generating arrangement adapted to generate said stationary magnetic field signal for said transponder. Said transponder is adapted to determine a plurality of signal strengths of said received magnetic field signal. The system further comprises at least one signal receiving arrangement, adapted to receive said further signal of said transponder. Said transponder is adapted to insert at least one message portion in said further signal, indicative of at least one of said plurality of received signal strengths. Said system further comprises processing means adapted to determine said position in accordance with a plurality of said received signal strengths determined by said moving transponder. The further signal can e.g. be an electromagnetic signal of high frequency that has a high band width enabling the use of a large number of transponders in a sporting event.

DE 10 2015 010 398 A1 relates to sports timing. A sports timing transponder is disclosed. The sports timing transponder comprises a receiving unit for receiving at least one message from a measuring point as it passes the measuring point. The message includes a measuring point parameter indicating whether the past measuring point is an indirect measuring point or a direct measuring point. The transponder further comprises a process for calculating a passing time of the measuring point based on the at least one message. The transponder further includes a counter for determining a time difference between a passing time of an indirect measuring point and passing time of a direct measuring point. The transponder further includes a transmitting unit for transmitting the determined time difference to the direct measuring point when passing the direct measuring point. Further prior art can be found in EP2453415 B1 and US2012/087421 A1.

Relevant drawbacks of current systems are that the orientation/speed of the transponder or also external conditions such as the weather, the humidity or other transponders within range, can influence the measurements and thereby lead to inaccuracies when determining the passing time. The obvious and most common approach of determining the passing time is based on a determination of a point at which the highest signal strength is measured. This, however, can lead to inaccurately determined passing times. This is particularly caused by the complex 3D signals depending on the exact geometrical relations between the RFID loop antenna and the trajectory of the transponder (distance of the transponder to the loop, rotation of the transponder whilst passing the loop, orientation of the transponder versus the loop, etc.).

In view of the above, the present invention addresses the problem of providing a robust, efficient-to-calculate and accurate approach for determining a passing time of a transponder. In particular, it is desired to provide an approach to determine a passing time of a transponder in a sports event with high precision, i.e. a high correspondence between the actual point at which the transponder is at the minimal distance versus the loop antenna and the determined passing time. It is desired to provide an efficiently computable approach that may lead to an easy and cost-effective implementation.

To solve this problem, a first aspect of the present invention relates to a transponder for determining a passing time upon passing an RFID loop antenna, comprising:
- three inductive coils for measuring three field strength values of an activation signal transmitted by the RFID loop antenna upon passing the RFID loop antenna;
- a processing unit for determining an effective value of the three field strength values indicating an inductive field strength based on the three field strength values;
- an accumulation unit for collecting effective values for multiple activation signals over time and determining a time series of effective values; and
- a symmetry unit for determining a transponder passing time corresponding to a point in time within the time series at which effective values before and after the point in time have a maximum level of symmetry.

In another aspect, the present invention relates to a system for determining a passing time of a transponder, comprising:
- a transponder as defined above;
- an RFID loop antenna; and
- a receiver for receiving a transponder passing time and/or a time difference from a transponder passing the RFID loop antenna, said receiver particularly corresponding to a short-distance transceiver being arranged together with the RFID loop antenna in a timing assembly.

Further aspects of the present invention relate to a method corresponding to the transponder, a computer program which comprises program code means for causing the transponder to perform the steps of the method, when said program is carried out on the transponder, as well as a non-transitory computer-readable recording medium that stores therein a computer program product, which when executed by a processor, causes the method disclosed herein to be formed.

Preferred embodiments of the invention are defined in the dependent claims. It shall be understood that the claimed transponder, system and method and computer program have similar and/or identical preferred embodiments at the claimed transponder and system, in particular as defined in the dependent claims and as disclosed herein.

The present invention is based on the idea of determining the passing time by evaluating a symmetry in recorded field strength values. The field strength of the inductive field generated by the RFID loop antenna is measured by means of three inductive coils (a three-dimensional antenna). The three field strength values of these inductive coils are combined to determine an effective value. Said effective value presents the inductive field strength of the inductive RFID loop antenna. Multiple effective values are collected over time, in particular while the transponder passes the RFID loop antenna.

For instance, if the RFID loop antenna is arranged on the ground, in particular on a race track, the transponder may be carried by a runner running on said ground and passing over the RFID loop antenna. It is also possible that the transponder is attached to a vehicle or attached to an object for which a passing time is to be be determined. While passing the RFID loop antenna the effective values of the inductive field strength are recorded. The recording frequency could thereby be in the range of 150 read outs per second. Other ranges are also possible. These collected effective values in the time series of effective values are then analyzed to determine a point in time within this time series that corresponds to the passing time. For this, a symmetry is established/evaluated. A symmetry as used herein thereby particularly relates to the property of this time series to be transformed on itself (in a geometrical sense). In particular, a first part of the time series can be transformed to a second part of the time series wherein the first part of the time series and the second part of the time series are the parts before and after the desired point in time. In other words, the time series is analyzed in order to determine a point in time within the time series at which the values before and after are this point in time symmetrical to a certain degree. As used herein, the term symmetry or level of symmetry particularly relates to a reflectional symmetry or a line symmetry with respect to this point in time. If, as an example, a first point in time shortly before the passing time and a second point in time shortly after the passing time within equal time distance, have more or less the same effective value of the inductive field strength, a high symmetry is determined for this passing time.

In comparison to previous approaches in which the time series with the effective values is analyzed in order to determine a peak, the approach of the present invention allows a higher accuracy and higher precision. In other words, the determined passing time with the method of the present invention is closer to the actual (real) passing time than the passing time determined with the previous approaches, such as the peak detection. In particular, if the orientation of the transponder and the inductive coils in the transponder is undefined or also unknown or subject to change/rotation while the transponder passes the loop antenna, the approach of the present invention still leads to accurate results. Thus, the approach of the present invention enables a robust determination of the passing time of a transponder in a variety of different set-ups. Furthermore, the approach of the present invention allows an efficient determination of the passing time without requiring extensive processing capabilities. This also results in an energy saving potential. In addition, the passing time can be determined with high accuracy. In particular, the accuracy of the passing time determination can be higher than the actual repetition frequency of the transmission of activation signal by the RFID loop antenna. For instance, if the application signal is transmitted at 150 Hz, the approach can also lead to resolutions that are below 1/150 of a second.

In a preferred embodiment, the symmetry unit is configured to determine said point in time based on an integration of the effective values of said time series over time and/or based on a correlation of two parts of the time series. Alternatively, or additionally, the symmetry unit is configured to determine said point in time with a resolution that is higher than a time-span between successive transmissions of the activation signal. One preferred measure for determining the symmetry, or for providing the measure of the symmetry, can be an integral of the time series before and after the point in time corresponding to the passing time. In particular, different hypotheses for this point in time can be established and the desired point in time can be selected to correspond to the point in time at which the integral (i.e. the sum of the values) before and after is equal. It is thereby possible to consider a predefined or dynamically adjusted number of values in both directions. It is also possible to determine a corresponding measure based on the correlation of two parts of the time series. If the two parts before and after a point in time have a high correlation, this point in time has a high level of symmetry and can thereby be considered to correspond to the desired passing time. As discussed previously, the present invention allows to select a point in time as the passing time that is located between consecutive data points in the time series. In other words, a high precision of the determined passing time can be higher than the frequency of the transmission of the activation signal by the RFID loop antenna.

In a preferred embodiment, the processing unit is configured to determine the effective value based on a sum of squares of the three field strength values, preferably based on a square root of the sum of squares. Additionally, or alternatively the processing unit is configured to determine the effective value based on a pre-calculated look-up table. Determining a sum of squares of the three signal strength values leads to an effective value corresponding to the actual inductive field strength. In particular for this calculation, but also in other calculations, it can be advantageous to make use of a pre-calculated look-up table in order to save processing power. This may lead to an easier and more efficient computation and cost savings.

In a preferred embodiment, the accumulation unit is configured to collect the effective values until a pre-defined or a dynamically adjusted number of successive effective values are lower than a threshold, preferably a dynamically adjusted threshold. In order to determine a point in time at which the symmetry should be determined or evaluated, it is advantageous to make use of a dynamically adjusted threshold. As soon as no further values are received or the further received values are below the threshold, the passing is considered to have occurred (e.g. the finish line has been crossed) and the passing time can be determined. This above-defined criterion leads to an efficient calculation that is carried out as soon as the passing is finished. A dynamically adjusted threshold thereby particularly compensates for effects of different transponder positions versus the RFID loop antenna. For instance, a transponder that passes the RFID loop antenna at a higher trajectory than another may only register lower field strength values so that another threshold is advantageous.

In a preferred embodiment, the accumulation unit is configured to determine a symmetry parameter for the effective values while accumulating the received effective values. The accumulation unit is preferably configured to determine said symmetry parameter based on integrating or summing up the effective values upon availability. In particular, it is possible that the accumulation unit already determines a symmetry parameter while the inductive coils are still measuring field strength values. In other words, the symmetry parameter is already determined while the passing is still ongoing. This leads to a higher efficiency and a faster processing. One action for processing the received effective values while collecting further received effective values to determine the symmetry parameter thereby includes integrating or summing up the effective values directly upon availability. An efficient and fast processing is assured.

In a preferred embodiment, the transponder includes a transceiver for transmitting the transponder passing time and/or a transponder passing parameter derived from the transponder passing time to a receiver. Said transceiver preferably corresponds to a short-distance transceiver, in particular a 2.4 GHz transceiver. Additionally, or alternatively, the transponder includes a transmission timing unit for determining a time difference between the determined transponder passing time and a transmission time at which the transponder passing time and/or the time difference is transmitted to the receiver. In preferred embodiments it is possible that the transponder includes a transceiver which is then used to communicate with a receiver. The receiver can thereby, e.g., be integrated in a timing station that is arranged along a racetrack and that allows further processing of the passing time. The transmission timing unit particularly includes a clock that makes it possible to determine a time difference. Based on this time difference, it becomes possible to transform a time basis of the transponder to a time basis of the receiver (which could particularly correspond to an absolute or real time basis). Usually, a transponder does not have an own time basis with sufficient accuracy to enable a comparison between passing times measured with different transponders (i.e. passing times of different participants). In other words, the clocks of different transponders usually drift against one another during a race or during the time of life of a transponder. To compensate for this, the transponder can be configured in such a way that it determines a time difference rather than an absolute time. This time difference can then be transmitted. If the time difference is transmitted and received by the receiver, the receiver can make use of this time difference to derive an absolute time by subtracting this time difference from the receiver's clock (showing an absolute time).

In a preferred embodiment, the transponder comprises the transceiver and the transmission timing unit. The transmission timing unit is configured to determine a desired transmission time corresponding to a point in time at which the transponder time and/or the time difference is transmitted to the receiver. Said transmission timing unit is preferably configured to determine the desired transmission time based on a power-up time of the transceiver corresponding to a minimum duration for reliably sending information via the transceiver. The transceiver is configured to transmit the transponder passing time and/or the time difference to the receiver at the desired transmission time. By making use of the desired transmission time, it becomes possible to make the communication between the transponder and the receiver deterministic to a certain degree. In particular, it becomes possible to assure that the communication with the receiver can actually be established prior to communicating the determined passing time or time difference to the receiver. Further, the desired transmission time can also be used to avoid congestion in applications where a large number of transponders are used simultaneously. It can be assured that the different transponders (their transceivers) do not interfere with one another when communicating with the receiver. Still further, it becomes possible to increase the reliability of communication with the receiver.

In a preferred embodiment, the transponder comprises the transceiver and the transmission timing unit. The transmission timing unit is configured to determine the desired transmission time based on a receiver parameter of a receiver within range of the transceiver. The transmission timing unit is preferably configured to determine a later transmission time if the receiver parameter indicates the receiver cannot communicate with a mobile data network. This receiver parameter can be obtained by means of communication of the transponder with the receiver. It can also be predefined or preprogrammed on the transponder. In particular, the receiver parameter can thereby indicate whether or not the receiver can communicate via a mobile data network (i.e. is within communication range, has a mobile data connection etc.). In a set up in which the transponder passes multiple receivers whilst being on a racetrack, it is possible that some of these receivers have no use for the passing time. A reason for this could be that the respective receiver has no connection to a mobile data network due to its location. In this case, it is not necessary that the passing time and/or time difference be communicated to this receiver. Instead, the passing time should rather be communicated to the following or post-following receiver (along the race track) which can further process the passing time and/or time difference (in particular by communicating it to a central server for further evaluation and comparison with other passing times of other participants in the race). In particular, it is possible that the transponder passes a first receiver corresponding to a first split time position along a race track, and determines the passing time at said first receiver via an RFID loop antenna arranged at that first receiver. The transponder, however, only communicates the determined passing time at a later stage of the race track to another receiver that could, e.g., be integrated into a timing position at the finish of the race track. The transmission of the determined passing time can, in other words, be delayed. One effect of this arrangement is that both bandwidth and energy can be saved since unnecessary transmissions are avoided.

In a preferred embodiment, the transponder comprises the transceiver and the transmission timing unit. The transmission timing unit is configured to determine an updated time difference if no confirmation of receipt is obtained from the receiver after the transponder passing time and/or the time difference has been transmitted. The transceiver is configured to transmit the updated time difference to the receiver. It can particularly be advantageous to make the determination of the time difference dependent upon whether or not the corresponding data packet, including the transmission time and/or time difference in the communication to the receiver, is received by the receiver. If no acknowledgement of receipt is obtained, the data packet is re-transmitted with an updated time difference. The further processing when transforming the passing time of the transponder to the time basis of the receiver or the timing system is improved.

In a preferred embodiment, the three inductive coils are arranged orthogonal to one another in three orthogonal directions. This arrangement allows an efficient and accurate determination of the inductive field strength.

In a preferred embodiment of the system of the present invention, the receiver is configured to determine an absolute passing time of the transponder based on the transponder passing time and/or time difference and an absolute time in the moment of signal reception, in particular by subtracting the time difference from the absolute time. An absolute time as used herein particularly relates to a time as determined by an authority such as the Physikalisch-Technische Bundesanstalt (PTB) in Germany or the National Institute of Standards and Technology (NIST) in the US. The concept of absolute time, as used herein, refers in particular to a time specification based on the time of such an authority. Thus, the absolute time as used herein corresponds to an official time for a particular area (or for the world). In order to determine the absolute passing time, the time difference determined in the transponder can be subtracted from the absolute time to thereby transform the time basis of the transponder to the absolute time basis as derived, e.g. from a GPS receiver and/or based on an internal high precision clock.

In a preferred embodiment of the system, the receiver is configured to determine the absolute time (and the absolute passing time) based on a signal of a GPS receiver and/or based on an internal high precision clock.

Herein, a transponder particularly refers to an active RFID sports timing transponder or active RFID tag. The transponder, method and system disclosed herein are particularly suitable for timing in a sports event but may also be used in other application areas. A sports event is particularly a running event such as a marathon or the like. However, a sports event can also be a bike race, a car race, a ski race, a horse race, a swimming competition etc. A passing time can be indicated on different time bases. In particular an absolute time basis corresponding to an official time or a local time basis such as a time basis of a transponder, can be used for comparing passing times measured with different transponders that do not share a common (absolute) time basis.

These and other aspects of the invention will be apparent from and elucidated with reference to the embodiments described hereinafter. In the following drawings:
- Fig. 1: shows a schematic illustration of participants of a sports event wherein a passing time is measured by means of a system of the present invention;
- Fig. 2: shows a schematic illustration of a transponder according to the present invention;
- Fig. 3: shows a schematic illustration of simulations of the behavior of effective value while the transponder passes the RFID loop antenna;
- Fig. 4: shows an illustration of measurement values of three inductive coils in a transponder while passing an RFID loop antenna;
- Fig. 5: shows a schematic illustration of a race timing system based on a system of the present invention; and
- Fig. 6: shows a schematic illustration of a method according to an aspect of the present invention.

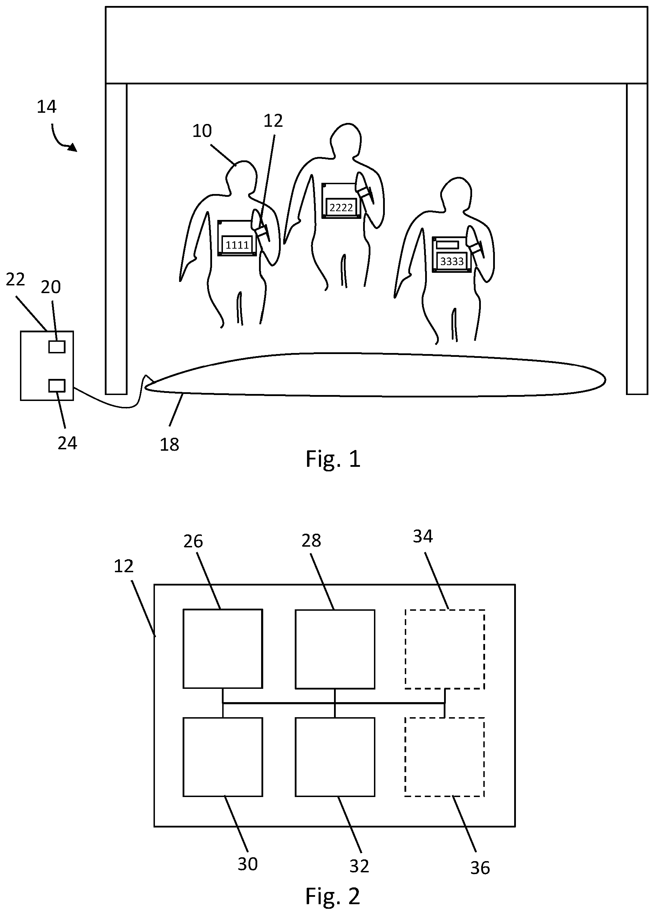

In Fig. 1 a situation with a plurality of participants 10 in a sports event is schematically illustrated. The participants 10 may, e.g., be runners in a running event such as a marathon or the like. For each participant, a passing time corresponding to the time when the participant 10 crosses the start or finish line or passes a split time measuring point, is to be measured. For this, a system 14 for measuring a passing time is used. The system 14 includes a transponder 12, which is carried by the participant to identify the participant 10 and to carry out a measurement. The system 14 further includes an RFID loop antenna 18 and a receiver 20.

In the illustrated embodiment the receiver 20 is integrated in a timing station 22. This timing station 22 may particularly correspond to a case or a robust housing that includes the necessary processing and control capabilities for controlling the RFID loop antenna 18. The timing station 22 may, e.g., include or be based on a laptop computer. In the illustrated embodiment, the timing station 22 further includes a GPS receiver 24 which is not only capable of determining a position of the timing stations 22 but can also provide an accurate time signal reflecting a current absolute time. If multiple timing stations 22 are used together at split time positions and start/finish positions, these timing stations 22 usually communicate with a central (internet) server via mobile communication.

The determination of the passing time itself is usually based on the RFID loop antenna 18 transmitting an activation signal which is captured by the transponder 12. This activation signal is usually at a high (repetition) frequency, e.g. 150 Hz. Upon passing by or over the RFID loop antenna 18, the transponder 12 registers a plurality of activation signals. Based on these captured activation signals a point in time at which the distance between the transponder and the RFID loop antenna 18 is (or was) minimal can be determined. This point in time is then usually considered to correspond to the passing time. In previous approaches, this determination was usually based on a determination of the point in time at which the maximum signal strength is received. The approach of the present invention, instead, makes use of a symmetry consideration for determining the passing time.

Usually, the passing time is calculated in the transponder 12 and only the result of the calculation is then further processed. This is because the transponder 12 preferably has only limited energy supply and communication capabilities. Due to this, the determined passing time is also preferably not communicated via mobile communication but rather transmitted by means of a short distance communication to the receiver 20 of the timing station 22. The timing station 22 may then further process the passing time and, e.g. communicate it to a central server for access by spectators or participants. Since, in this approach, the passing time is usually determined on a (local) time basis of the transponder, since the transponder 12 does not have a sufficiently accurate internal lock, it is usually necessary to transform the passing time to an absolute timing time basis. This enables the comparison of times for different athletes/ transponders and times determined at different positions via different timing stations along the race track.

In Fig 2 a transponder 12 of the present invention is schematically illustrated. The transponder 12 includes three inductive coils 26, a processing unit 28, an accumulation unit 30 and a symmetry unit 32. In the illustrated embodiment, the transponder 12 further includes a (optional) transceiver 34 as well as a (optional) transmission timing unit 36. The different units can be implemented separately or combined with one another. In particular, it is possible that the functions provided by different units are provided by a single processor or multiple processors that are arranged in the transponder 12.

The three inductive coils 26 are used for measuring three field strength values of an activation signal, i.e. an inductive signal transmitted repetitively by the RFID loop antenna. The activation signal is measured multiple times while within range, i.e. while passing the RFID loop antenna. The three inductive coils 26 are preferably arranged orthogonal to one another in three orthogonal directions. Thus, three differently orientated values for the field strength can be measured. Three inductive coils 26 measure the field strengths in three directions.

The processing unit 28 is used to derive an effective value (effective field strength) from the three measured field strength values. This effective value indicates an inductive field strength. Thereby, the effective value may particularly be determined by making use of a sum of squares and calculating the square root of this sum of squares. In other words, a vector representing the field strength of the inductive field can be used as the effective value. The processing unit 28 thereby determines this effective value preferably as soon as the (three) measurements of the three field strength values are available, i.e. directly upon collecting the measurements and without waiting for the measurement of all values during a passing to be completed. The processing unit 28 may thereby include a pre-calculated look-up table that already includes pre-calculated values for the square root. This enables the saving of processing power and energy. A look-up operation is usually more efficiently implementable than a calculation.

In the accumulation unit 30 the determined effective values are collected over time while the transponder passes the RFID loop antenna and a time series of effective values is determined. For this, the accumulation unit 30 may particularly correspond to a data storage. The time series of effective values may particularly be stored in the form of a corresponding multi-dimensional vector. The accumulation unit 30 can preferably be configured to start accumulating the values as soon as the first value is detected, or as soon as a value above a predefined or dynamically adjusted threshold is detected. Further, alternatively or correspondingly, the accumulation unit 30 may be configured to stop collecting effective values as soon as a number of successive effective values are lower than a threshold. This threshold can thereby preferably be a dynamically adjusted threshold that allows compensating for effects resulting from a greater (or smaller) distance between the transponder and the RFID loop antenna. Still further, the accumulation unit 30 may already upon reception of the received effective values do a pre-processing or online-processing to derive a symmetry parameter. This symmetry parameter can then be used in the further calculation in the symmetry unit to calculate the level of symmetry. For instance, the accumulation unit 30 may be configured to integrate (sum up) the effective values upon reception while the transponder passes the RFID loop antenna.

The symmetry unit 32 processes the time series of effective values to determine a transponder passing time. This transponder passing time corresponds to an indication of time on a time basis of the transponder. This time basis of the transponder can either be an absolute time or be a local time. Usually, the transponder will only have a local time and no accurate absolute time, since the transponder's internal clock is not very accurate due to processing and energy restrictions. The symmetry unit 32 is configured to analyze the time series to determine a point in time within said time series at which the effective values in the time series before and after the point in time have a maximum level of symmetry. In particular, this point in time may not only coincide with one of the data points in the time series, but may also lie between two consecutive data points (effective values). This means that the accuracy of determining the passing time is higher than the frequency of the transmission of the activation signal by the RFID loop antenna. A higher resolution can be obtained. The symmetry unit 32 may thereby be configured to make use of a predetermined symmetry parameter that has already been determined during the accumulation of the effective values and that corresponds to some sort of pre-processing result of the incoming values. Usually, the symmetry unit 32 will analyze the symmetry by making a hypothesis and refining this hypothesis by integrating the data points before and after the hypothesis. Other approaches may include analyzing a correlation between two parts of the time series.

The (optional) transceiver 34 is used to communicate the transponder passing time or a parameter derived from the transponder passing time from the transponder to the receiver of the system. In particular, a 2.4 GHz transceiver can be used for this. The transceiver 34 may communicate different pieces of information to the receiver. In particular, the transceiver 34 may be configured to communicate a single data packet in order to save energy and processing power.

The (optional) transmission timing unit 36 is used for determining a time difference between the determined transponder passing time and a transmission time at which the communication to the receiver is established. In particular, if the passing time is determined on a time basis of the transponder it would make only limited sense to communicate said passing time without further processing since the receiver would not be able to transform said transponder passing time to an absolute time basis. For this, the transmission timing unit 36 can determine a time difference between the passing time and the time of sending (transmission time). If this time difference is then communicated to the receiver, the receiver can subtract the time difference from its own current time in order to determine the passing time on the time basis of the receiver, i.e. the receiver passing time. If the receiver has an accurate (absolute) time basis, it is possible to determine the passing time based thereupon. Thereby, the transmission unit 36 may also determine a desired transmission time and control the transceiver 34 so that it transmits the transponder passing time and/or the time difference at this determined desired transmission time. This may lead to a reliable transmission of the data packet to the receiver. Thereby, congestion in applications where multiple short distance receivers are within range of one another can be avoided. The transmission timing unit 36 may also be configured to make use of a receiver parameter that relates to the receiver currently in range of the transceiver 36. If this receiver, e.g., is not capable of processing or communicating the passing time and the information from the transponder it may not be necessary to communicate the passing time and/or the time difference to this receiver. For instance, if the receiver is located in a position where no mobile communication is possible or no network communication can be established, it may make sense to only communicate the determined passing time and/or time difference to another receiver at a later stage, e.g. a receiver located at the next timing position of a race track.

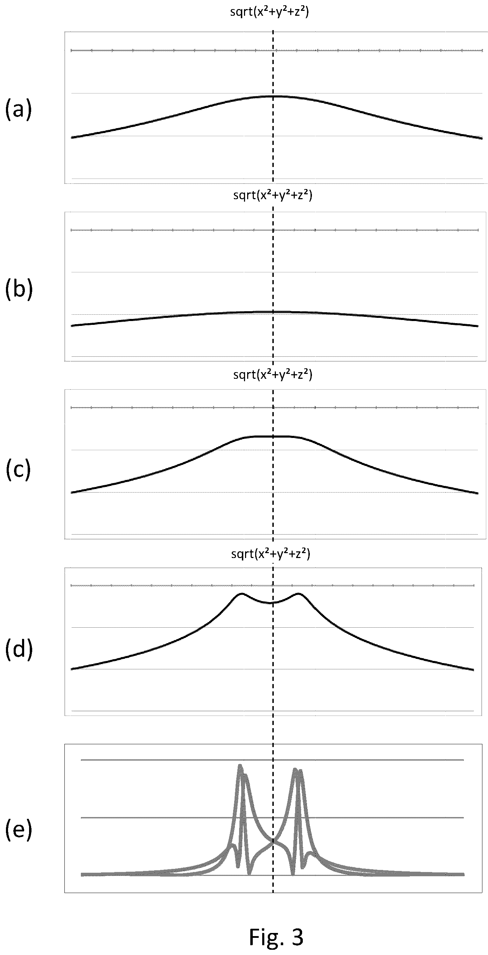

Fig. 3 schematically illustrates simulated data for the signal strength of an inductive field (on the y-axis, i.e. the vertical axis) over time (on the x-axis, i.e. the horizontal axis). The behavior of the field strength while passing the RFID loop antenna (i.e. the two cables of the loop) is illustrated. In particular, an effective value of the field strength corresponding to a square root of a sum of squares of the values measured by three orthogonally arranged inductive coils is illustrated. Upon approaching the RFID loop antenna, the signal strength generally increases. After having passed the RFID loop antenna, the signal strength generally decreases. The dashed line represents a position of a center of the RFID loop antenna. It is desired to derive the point in time corresponding to the position of the dashed line.

Current approaches for determining the passing time usually make use of the signal strength and are based on determining a maximum signal strength of the inductive field. The four examples in Fig. 3 (a) to Fig. 3 (d) illustrate simulations of signal strengths for different positions/movement characteristics of the transponder.

Fig. 3 (a) illustrates a situation in which the distance between the transponder and the RFID loop antenna corresponds to the width of the loop. This represents an ideal case in which it would generally be possible to determine a passing time corresponding to a time at which the maximum field strength is detected. Fig. 3 (b) illustrates a situation in which the distance between the transponder and the RFID loop antenna is three times the width of the loop. This results in a flat maximum, in particular if noise is considered (not depicted). An accurate determination of the passing time based on a maximum is hardly possible. Fig. 3 (c) illustrates a situation in which a distance between the transponder and the antenna is about half the width of the loop. As illustrated, no real maximum exists in this situation. Figs. 3 (d) and 3 (e) illustrate an exemplary situation in which the distance between the transponder and the RFID loop antenna is about 1/6 of the width of the loop. Also, it is considered that the transponder turns slowly. In Fig. 3 (e), the absolute values of the field strengths registered by two of the three inductive coils are illustrated. In this situation the third inductive coil would, due to its orientation, not detect the inductive field. The two axes are considered individually. Fig. 3 (d) shows the sum of squares. It can be seen that this situation does not result in a distinct maximum.

Referring to Fig. 3, one major problem when determining the signal strength and, based upon this, deriving the passing time, is that the determination of a maximum is only valid under very specific conditions, i.e. for a certain distance between the transponders and the RFID loop antenna. From a three-dimensional perspective, this premise that the signal strength is meaningful for the crossing of the center of the loop is only valid for a minimum distance between the transponder and the loop (Fig. 3 (a) versus Fig. 3 (c)). If the distance is lower, no maxima (Fig. 3 (c)) or two maxima (Fig. 3 (d)) may be derivable. At higher distances, the maximum may become very flat and difficult to determine (Fig. 3 (b)). The signal strength itself is therefore only of limited suitability for determining a passing time. For approaches for determining the passing time of the state of the art that rely on phase determination, a significantly higher measurement effort is necessary.

Another difficulty when determining the passing time based on a maximum in the signal strength is that a specific alignment of at least one of the inductive coils of the transponder is required. If the alignment is unknown or the transponder changes its position or alignment in space while passing, the measurement result could be falsified.

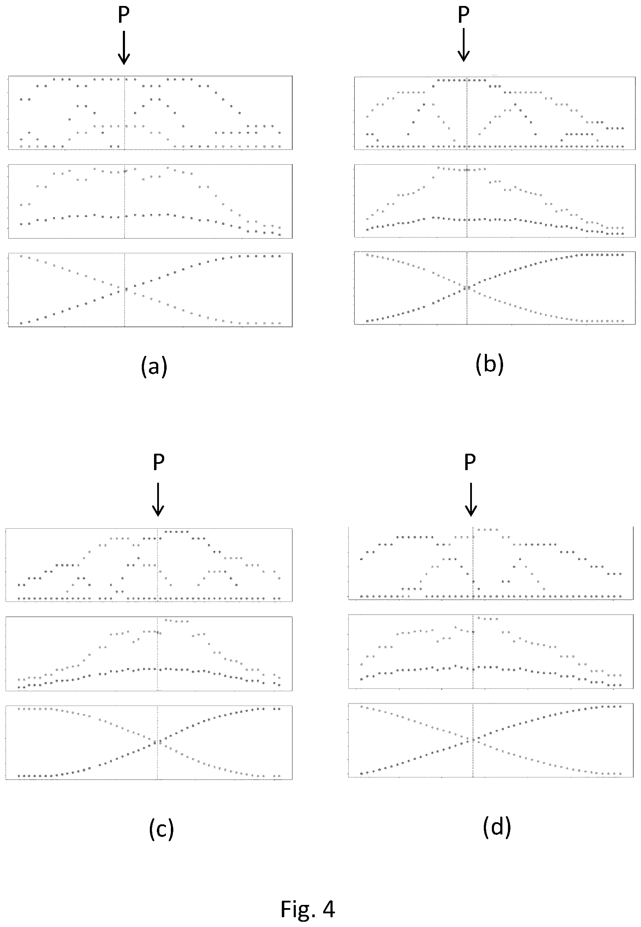

Fig. 4 schematically illustrates the determination of the passing time according to the present invention based on experimental data. In each of the four examples (a) to (d), the x-axis (horizontal axis) is a time axis. The arrows indicate the determined point in time P corresponding to the passing times.

The respective upper diagram shows on the y-axis (vertical axis) experimentally determined inductive field strength values. The different points correspond to measurements of the field strength of an activation signal transmitted by the RFID loop antenna. The activation signal may, e.g. be transmitted 150 times per second or more, depending on the application. The inductive field is measured in three directions via three inductive coils aligned orthogonal to one another. The data points in the respective upper diagrams correspond to the measurements in the three directions (blue, red and green dots). The respective middle diagram shows on the y-axis geometric sums corresponding to effective values at each point in time. In particular, this geometric sum is determined by calculating a square root of a sum of squares. The blue dots show geometric sums of the logarithmic measurement values. The orange dots show the geometric sums without the taking of the logarithm. The respective lower diagram corresponds to an exemplary approach for determining a point at which a maximum level of symmetry is obtained. The blue and orange dots show the integral, i.e. the area under the geometric sum-curves of the middle diagram, considered from the left and right sides. The desired point in time is determined to correspond to the point in time at which the areas are equal, i.e. the curves represented by the dots in the lower diagrams intersect.

Fig. 4 (a) illustrates measurements in a situation in which the transponder is inclined in all three dimensions. Fig. 4 (b) illustrates a situation in which the transponder is aligned optimally versus to the RFID loop antenna. Fig. 4 (c) illustrates a situation in which the transponder is inclined in a single dimension. Fig. 4 (d) illustrates a situation in which the transponder is inclined in another single dimension.

Referring to Figs. 3 and 4, one important observation is that a search for a point in time with the highest signal strength or phase shift may be too short-sighted a view of the three-dimensionality of the problem. Thus, passing times that are determined based on these approaches may be inaccurate. The approach of the present invention is based on the idea that an effective value, derived from three field strength values measured by three inductive coils, usually has a high degree of symmetry around the middle of the RFID loop antenna. At the point in time at which this inductive field strength (in particular the geometric sum of the three field strength values) has the highest degree of symmetry in both time directions, the transponder has most probably been located at the center of the RFID loop antenna. For this to be true, the transponder must be moved over the RFID loop antenna at an altitude that is only slightly variable (on a leg of a participant in a marathon, on a bike etc.) and at a speed that is only slightly variable (no major accelerations/decelerations directly while crossing the finish line).

Empirically, it has been shown that this applies in most cases at sports events and in other applications. However, the orientation of the transponder in space and any rotation that may occur (e.g. on the participant's leg) have virtually no effect on the determined passing time.

In a preferred embodiment, the approach of the present invention works as follows: a geometric sum is calculated for each triple of measured field strength values and stored in a memory (accumulation unit). When the signal strength has fallen below a threshold and/or no more activation by the RFID loop antenna can be measured, the values in the memory are analyzed and the point in time is determined at which a maximum degree of symmetry can be found in both time directions (symmetry unit). A correlation or a simple integration can be used for this purpose. A further optimization can consist in preparing this calculation at least partially already during the data acquisition so that computing time can be minimized during evaluation.

One consequence of the approach of the present invention is that the signal chain from storing a time stamp in the time-keeping system becomes more important. Since the approach of the invention leads to more accurate results, inaccuracies resulting from further processing steps can have high impact. One approach to minimize such inaccuracies can consist in sending a data packet with this information (the passing time or the time difference) at a planned or desired transmission time. In particular, a time difference can be sent at this desired transmission time. For this, a maximum duration for the start of a radio periphery, in particular a 2.4GHz radio periphery, can be assumed. Then, the transmission can be artificially delayed until this point in time. The time of reception is then set in relation to the current time, i.e. the absolute time or the real time at the receiver, by subtracting the time difference.

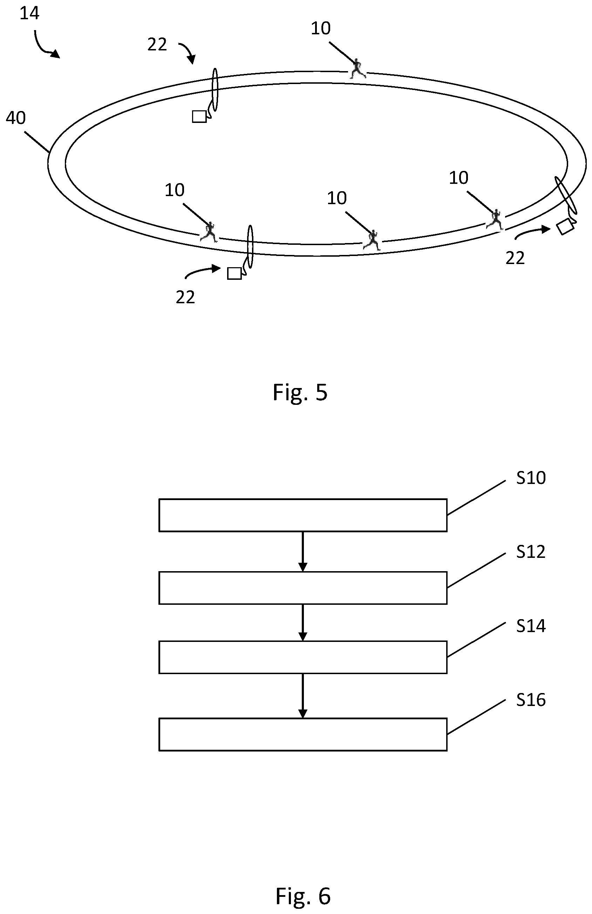

In Fig. 5 the situation at a race track 40 is schematically illustrated. The passing times are determined by means of a system 14 of the present invention. The participants 10 (runners) each carry a transponder (not illustrated). The passing time of the transponder is determined upon passing different timing stations 22 and the RFID loop antennas connected thereto. One of the timing stations may, e.g. correspond to a start/finish, whereas the other timing stations 22 may correspond to split time positions.

Preferably, the passing time (or a time difference) is determined in the transponder and then communicated to a receiver in the timing station 22 via short distance communication. In an embodiment of the system 14, it is possible that the transponder transmits the determined passing time to the timing station 22 (or the receiver of the timing station) that it has just passed, i.e. the timing station 22 or loop for which the passing time has actually been calculated. It is, however, also possible that transponder only transmits the passing time at a later stage, e.g. to the receiver integrated in the timing station 22 at the finish line. This may allow the saving of resources in cases in which a further processing of the determined passing time cannot be realized at one of the timing stations, for instance due to a lack of a mobile communication network at this specific position. To determine whether or not the passing time is to be transmitted to a timing station 22, a parameter of the receiver currently in range (receiver parameter) may be considered. This receiver parameter may be determined in a communication with the receiver or may also be predefined for the specific event, geographical situation, desired split time evaluation etc. If the passing time (or time difference) is not communicated to the receiver currently in range, it may be communicated to the next receiver in the next timing station 22 along the race track 40. For this, it may be necessary to recalculate a time difference or other parameter to be communicated to the receiver.

In Fig. 6 a method for determining the passing time of a transponder according to the present invention is schematically illustrated. The method includes steps of measuring S10 three field strength values, determining S12 an effective value, collecting S14 effective values of time and determining S16 a transponder's passing time. The method may particularly be implemented in software to be executed on a transponder.

In particular, the different circuitries are described with respect to their function. This functionality can be obtained by soft- and/or hardware. For instance, it is possible that the respective functionality is partly or completely implemented in a software running on a microcontroller. Thus, each calculation unit may include a microcontroller implementing the respective functions either alone or in communication and interaction with further passive or active electrical components such as resistors, capacitors and inductors.

The foregoing discussion discloses and describes merely exemplary embodiments of the present disclosure. Accordingly, the description is intended to be illustrative, but not limiting the scope of the disclosure, as well as other claims.

In the claims, the word "comprising" does not exclude other elements or steps, and the indefinite article "a" or "an" does not exclude a plurality. A single element or unit may fulfill the functions of several items recited in the claims. The mere fact that certain measures are recited in mutually different dependent claims does not indicate that a combination of these measures cannot be used to advantage.

The elements and units of the disclosed appliances, devices, circuitry and system may be implemented by corresponding hardware and/or software elements, for instance appropriated circuits. A circuit is a structural arrangement of electronic components including conventional circuit elements, integrated circuits including application-specific integrated circuits, standard integrated circuits, application-specific standard products, and field programmable gate arrays. Further a circuit includes central processing units, graphics processing units, and microprocessors which are programmed or configured according to software code. A circuit does not include pure software, although a circuit includes the above-described hardware executing software.

## Claims

1. Transponder (12) for determining a passing time upon passing an RFID loop antenna (18), comprising:
three inductive coils (26) for measuring three field strength values of an activation signal transmitted by the RFID loop antenna upon passing the RFID loop antenna;
a processing unit (28) for determining an effective value of the three field strength values indicating an inductive field strength based on the three field strength values;
an accumulation unit (30) for collecting effective values for multiple activation signals over time and determining a time series of effective values; **characterised by** the transponder (12) comprising:
a symmetry unit (32) for determining a transponder passing time corresponding to a point in time (P) within the time series at which effective values before and after the point in time have a maximum level of symmetry.

2. Transponder (12) as claimed in claim 1, wherein the symmetry unit (32) is configured to determine said point in time (P)
based on an integration of the effective values of said time series over time and/or based on a correlation of two parts of the time series; and/or with a resolution that is higher than a time span between successive transmissions of the activation signal.

3. Transponder (12) as claimed in any one of the preceding claims, wherein the processing unit (30) is configured to determine the effective value
based on a sum of squares of the three field strength values, preferably based on a square root of the sum of squares; and/or
based on a pre-calculated look-up table.

4. Transponder (12) as claimed in any one of the preceding claims, wherein the accumulation unit (28) is configured to collect the effective values until a predefined or dynamically adjusted number of successive effective values are lower than a threshold, preferably a dynamically adjusted threshold.

5. Transponder (12) as claimed in any one of the preceding claims, wherein
the accumulation unit (28) is configured to determine a symmetry parameter for the effective values while accumulating the received effective values; and
the accumulation unit is preferably configured to determine said symmetry parameter based on integrating or summing up the effective values upon availability.

6. Transponder (12) as claimed in any one of the preceding claims, including
a transceiver (34) for transmitting the transponder passing time and/or a transponder passing parameter derived from the transponder passing time to a receiver (20), wherein said transceiver preferably corresponds to a short-distance transceiver, in particular a 2.4 GHz transceiver; and/or
a transmission timing unit (36) for determining a time difference between the determined transponder passing time and a transmission time at which the transponder passing time and/or the time difference is transmitted to a receiver.

7. Transponder (12) as claimed in claim 6, comprising the transceiver (34) and the transmission timing unit (36), wherein
the transmission timing unit is configured to determine a desired transmission time corresponding to a point in time at which the transponder passing time and/or the time difference is transmitted to the receiver (20), said transmission timing unit preferably being configured to determine the desired transmission time based on a power-up time of the transceiver corresponding to a minimum duration for reliably sending information via the transceiver; and
the transceiver is configured to transmit the transponder passing time and/or the time difference to the receiver at the desired transmission time.

8. Transponder (12) as claimed in any one of claims 6 and 7 comprising the transceiver (34) and the transmission timing unit (36), wherein
the transmission timing unit is configured to determine the desired transmission time based on a receiver parameter of a receiver (20) within range of the transceiver; and
the transmission timing unit is preferably configured to determine a later transmission time if the receiver parameter indicates that the receiver cannot communicate via a mobile data network.

9. Transponder (12) as claimed in any one of claims 6 to 8 comprising the transceiver (34) and the transmission timing unit (36), wherein
the transmission timing unit is configured to determine an updated time difference if no confirmation of receipt is obtained from the receiver (20) after the transponder passing time and/or the time difference has been transmitted; and
the transceiver is configured to transmit the updated time difference to the receiver.

10. Transponder (12) as claimed in any one of the preceding claims, wherein the three inductive coils (26) are arranged orthogonal to one another in three orthogonal directions.

11. System (14) for determining a passing time of a transponder (12), comprising:
a transponder (12) as claimed in any one of the preceding claims;
an RFID loop antenna (18); and
a receiver (20) for receiving a transponder passing time and/or a time difference from a transponder passing the RFID loop antenna, said receiver particularly corresponding to a short-distance transceiver being arranged together with the RFID loop antenna in a timing assembly.

12. System (14) as claimed in claim 11, wherein the receiver (20) is configured to determine an absolute passing time of the transponder based on the transponder passing time and/or time difference and an absolute time in the moment of signal reception, in particular by subtracting the time difference from the absolute time.

13. System (14) as claimed in any one of claims 11 and 12, wherein the receiver (20) is configured to determine the absolute time based on a signal from a GPS receiver (24) and/or based on an internal high precision clock.

14. Method for determining a passing time of a transponder (12) upon passing an RFID loop antenna (18), the method being carried out by a transponder as claimed in any one of claims 1 to 10, comprising the steps:
measuring (S10) three field strength values of an activation signal transmitted by the RFID loop antenna upon passing the RFID loop antenna; determining (S12) an effective value of the three field strength values indicating an inductive field strength based on the three field strength values;
collecting (S14) effective values for multiple activation signals over time and determining a time series of effective values; **characterised by** the method comprising the step of:
determining (S16) a transponder passing time corresponding to a point in time (P) within the time series at which effective values before and after the point in time have a maximum level of symmetry.

15. Computer program comprising program code means for causing a transponder as claimed in any one of claims 1 to 10 to carry out the steps of the method as claimed in claim 14 when said computer program is carried out on the transponder.

## Patentansprüche

1. Transponder (12) zur Bestimmung einer Passierzeit beim Passieren einer RFID-Schleifenantenne (18), umfassend:
drei Induktionsspulen (26) zum Messen von drei Feldstärkewerten eines von der RFID-Schleifenantenne gesendeten Aktivierungssignals beim Passieren der RFID-Schleifenantenne;
eine Verarbeitungseinheit (28) zum Bestimmen eines Effektivwerts der drei Feldstärkewerte, der eine induktive Feldstärke anzeigt, basierend auf den drei Feldstärkewerten;
eine Akkumulationseinheit (30) zum Sammeln von Effektivwerten für mehrere Aktivierungssignale über die Zeit und zum Bestimmen einer Zeitreihe von Effektivwerten; **dadurch gekennzeichnet, dass** der Transponder (12) umfasst:
eine Symmetrieeinheit (32) zum Bestimmen einer Transponder-Passierzeit entsprechend einem Zeitpunkt (P) innerhalb der Zeitreihe, zu dem Effektivwerte vor und nach dem Zeitpunkt ein maximales Maß an Symmetrie aufweisen.

2. Transponder (12) nach Anspruch 1, wobei die Symmetrieeinheit (32) dazu konfiguriert ist, den Zeitpunkt (P) zu bestimmen
basierend auf einer Integration der Effektivwerte der Zeitreihe über die Zeit und/oder basierend auf einer Korrelation zweier Teile der Zeitreihe; und/oder
mit einer Auflösung, die höher ist als eine Zeitspanne zwischen aufeinanderfolgenden Übertragungen des Aktivierungssignals.

3. Transponder (12) nach einem der vorhergehenden Ansprüche, wobei die Verarbeitungseinheit (30) dazu konfiguriert ist, den Effektivwert zu bestimmen
basierend auf einer Summe der Quadrate der drei Feldstärkewerte, vorzugsweise basierend auf einer Quadratwurzel der Summe der Quadrate; und/oder
basierend auf einer vorberechneten Nachschlagetabelle.

4. Transponder (12) nach einem der vorhergehenden Ansprüche, wobei die Akkumulationseinheit (28) dazu konfiguriert ist, die Effektivwerte zu sammeln, bis eine vordefinierte oder dynamisch angepasste Anzahl aufeinanderfolgender Effektivwerte niedriger als ein Schwellenwert ist, vorzugsweise ein dynamisch angepasster Schwellenwert.

5. Transponder (12) nach einem der vorhergehenden Ansprüche, wobei
die Akkumulationseinheit (28) dazu konfiguriert ist, einen Symmetrieparameter für die Effektivwerte zu bestimmen, während die empfangenen Effektivwerte akkumuliert werden; und
die Akkumulationseinheit vorzugsweise dazu konfiguriert ist, den Symmetrieparameter basierend auf dem Integrieren oder Aufsummieren der Effektivwerte bei Verfügbarkeit zu bestimmen.

6. Transponder (12) nach einem der vorhergehenden Ansprüche, umfassend
einen Transceiver (34) zum Übertragen der Transponder-Passierzeit und/oder eines von der Transponder-Passierzeit abgeleiteten Transponder-Durchgangsparameters an einen Empfänger (20), wobei der Transceiver vorzugsweise einem Kurzstrecken-Transceiver entspricht, insbesondere einem 2,4-GHz-Transceiver; und/oder
eine Übertragungszeitsteuerungseinheit (36) zum Bestimmen einer Zeitdifferenz zwischen der bestimmten Transponder-Passierzeit und einer Übertragungszeit, zu der die Transponder-Passierzeit und/oder die Zeitdifferenz an einen Empfänger übertragen wird.

7. Transponder (12) nach Anspruch 6, umfassend den Transceiver (34) und die Übertragungszeitsteuerungseinheit (36), wobei
die Übertragungszeitsteuerungseinheit dazu konfiguriert ist, eine gewünschte Übertragungszeit zu bestimmen, die einem Zeitpunkt entspricht, zu dem die Transponder-Passierzeit und/oder die Zeitdifferenz an den Empfänger (20) übertragen wird, wobei die Übertragungszeitsteuerungseinheit vorzugsweise dazu konfiguriert ist, die gewünschte Übertragungszeit basierend auf einer Einschaltzeit des Transceivers zu bestimmen, die einer Mindestdauer für das zuverlässige Senden von Informationen über den Transceiver entspricht; und
der Transceiver dazu konfiguriert ist, die Transponder-Passierzeit und/oder die Zeitdifferenz zur gewünschten Übertragungszeit an den Empfänger zu übertragen.

8. Transponder (12) nach einem der Ansprüche 6 und 7, umfassend den Transceiver (34) und die Übertragungszeitsteuerungseinheit (36), wobei
die Übertragungszeitsteuerungseinheit dazu konfiguriert ist, die gewünschte Übertragungszeit basierend auf einem Empfängerparameter eines Empfängers (20) innerhalb der Reichweite des Transceivers zu bestimmen; und
die Übertragungszeitsteuerungseinheit vorzugsweise dazu konfiguriert ist, eine spätere Übertragungszeit zu bestimmen, wenn der Empfängerparameter anzeigt, dass der Empfänger nicht über ein Mobilfunknetz kommunizieren kann.

9. Transponder (12) nach einem der Ansprüche 6 bis 8, umfassend den Transceiver (34) und die Übertragungszeitsteuerungseinheit (36), wobei
die Übertragungszeitsteuerungseinheit dazu konfiguriert ist, eine aktualisierte Zeitdifferenz zu bestimmen, wenn keine Empfangsbestätigung vom Empfänger (20) erhalten wird, nachdem die Transponder-Passierzeit und/oder die Zeitdifferenz übertragen wurde; und
der Transceiver dazu konfiguriert ist, die aktualisierte Zeitdifferenz an den Empfänger zu übertragen.

10. Transponder (12) nach einem der vorhergehenden Ansprüche, wobei die drei Induktionsspulen (26) orthogonal zueinander in drei orthogonalen Richtungen angeordnet sind.

11. System (14) zur Bestimmung einer Passierzeit eines Transponders (12), umfassend:
einen Transponder (12) nach einem der vorhergehenden Ansprüche;
eine RFID-Schleifenantenne (18); und
einen Empfänger (20) zum Empfangen einer Transponder-Passierzeit und/oder einer Zeitdifferenz von einem Transponder, der die RFID-Schleifenantenne passiert, wobei der Empfänger insbesondere einem Kurzstrecken-Transceiver entspricht, der zusammen mit der RFID-Schleifenantenne in einer Zeitmessungsanordnung angeordnet ist.

12. System (14) nach Anspruch 11, wobei der Empfänger (20) dazu konfiguriert ist, eine absolute Passierzeit des Transponders basierend auf der Transponder-Passierzeit und/oder Zeitdifferenz und einer absoluten Zeit im Moment des Signalempfangs zu bestimmen, insbesondere durch Subtrahieren der Zeitdifferenz von der absoluten Zeit.

13. System (14) nach einem der Ansprüche 11 und 12, wobei der Empfänger (20) dazu konfiguriert ist, die absolute Zeit basierend auf einem Signal eines GPS-Empfängers (24) und/oder basierend auf einer internen Hochpräzisionsuhr zu bestimmen.

14. Verfahren zur Bestimmung einer Passierzeit eines Transponders (12) beim Passieren einer RFID-Schleifenantenne (18), wobei das Verfahren von einem Transponder nach einem der Ansprüche 1 bis 10 ausgeführt wird, umfassend die Schritte:
Messen (S10) von drei Feldstärkewerten eines von der RFID-Schleifenantenne gesendeten Aktivierungssignals beim Passieren der RFID-Schleifenantenne;
Bestimmen (S12) eines Effektivwerts der drei Feldstärkewerte, der eine induktive Feldstärke anzeigt, basierend auf den drei Feldstärkewerten;
Sammeln (S14) von Effektivwerten für mehrere Aktivierungssignale über die Zeit und Bestimmen einer Zeitreihe von Effektivwerten; **dadurch gekennzeichnet, dass** das Verfahren den Schritt umfasst:
Bestimmen (S16) einer Transponder-Passierzeit entsprechend einem Zeitpunkt (P) innerhalb der Zeitreihe, zu dem Effektivwerte vor und nach dem Zeitpunkt ein maximales Maß an Symmetrie aufweisen.

15. Computerprogramm, das Programmcodemittel umfasst, um einen Transponder nach einem der Ansprüche 1 bis 10 zu veranlassen, die Schritte des Verfahrens nach Anspruch 14 auszuführen, wenn das Computerprogramm auf dem Transponder ausgeführt wird.

## Revendications

1. Transpondeur (12) pour déterminer un temps de passage lors du passage d'une antenne boucle RFID (18), comprenant :
trois bobines inductives (26) pour mesurer trois valeurs d'intensité de champ d'un signal d'activation transmis par l'antenne boucle RFID lors du passage de l'antenne boucle RFID ;
une unité de traitement (28) pour déterminer une valeur effective des trois valeurs d'intensité de champ indiquant une intensité de champ inductif sur la base des trois valeurs d'intensité de champ ;
une unité d'accumulation (30) pour collecter des valeurs effectives pour de multiples signaux d'activation au fil du temps et déterminer une série temporelle de valeurs effectives ; **caractérisé en ce que** le transpondeur (12) comprend :
une unité de symétrie (32) pour déterminer un temps de passage du transpondeur correspondant à un moment dans le temps (P) au sein de la série temporelle auquel les valeurs effectives avant et après le moment dans le temps ont un niveau maximal de symétrie.

2. Transpondeur (12) selon la revendication 1, dans lequel l'unité de symétrie (32) est configurée pour déterminer ledit moment dans le temps (P)
sur la base d'une intégration des valeurs effectives de ladite série temporelle au fil du temps et/ou sur la base d'une corrélation de deux parties de la série temporelle ; et/ou
avec une résolution qui est supérieure à un intervalle de temps entre des transmissions successives du signal d'activation.

3. Transpondeur (12) selon l'une quelconque des revendications précédentes, dans lequel l'unité de traitement (30) est configurée pour déterminer la valeur effective
sur la base d'une somme des carrés des trois valeurs d'intensité de champ, de préférence sur la base d'une racine carrée de la somme des carrés ; et/ou
sur la base d'une table de correspondance précalculée.

4. Transpondeur (12) selon l'une quelconque des revendications précédentes, dans lequel l'unité d'accumulation (28) est configurée pour collecter les valeurs effectives jusqu'à ce qu'un nombre prédéfini ou ajusté dynamiquement de valeurs effectives successives soit inférieur à un seuil, de préférence un seuil ajusté dynamiquement.

5. Transpondeur (12) selon l'une quelconque des revendications précédentes, dans lequel
l'unité d'accumulation (28) est configurée pour déterminer un paramètre de symétrie pour les valeurs effectives tout en accumulant les valeurs effectives reçues ; et
l'unité d'accumulation est de préférence configurée pour déterminer ledit paramètre de symétrie sur la base de l'intégration ou de la sommation des valeurs effectives dès leur disponibilité.

6. Transpondeur (12) selon l'une quelconque des revendications précédentes, comprenant
un émetteur-récepteur (34) pour transmettre le temps de passage du transpondeur et/ou un paramètre de passage du transpondeur dérivé du temps de passage du transpondeur à un récepteur (20), ledit émetteur-récepteur correspondant de préférence à un émetteur-récepteur à courte distance, en particulier un émetteur-récepteur à 2,4 GHz ; et/ou
une unité de synchronisation de transmission (36) pour déterminer une différence de temps entre le temps de passage du transpondeur déterminé et un temps de transmission auquel le temps de passage du transpondeur et/ou la différence de temps est transmis à un récepteur.

7. Transpondeur (12) selon la revendication 6, comprenant l'émetteur-récepteur (34) et l'unité de synchronisation de transmission (36), dans lequel
l'unité de synchronisation de transmission est configurée pour déterminer un temps de transmission souhaité correspondant à un moment dans le temps auquel le temps de passage du transpondeur et/ou la différence de temps est transmis au récepteur (20), ladite unité de synchronisation de transmission étant de préférence configurée pour déterminer le temps de transmission souhaité sur la base d'un temps de mise sous tension de l'émetteur-récepteur correspondant à une durée minimale pour envoyer de manière fiable des informations via l'émetteur-récepteur ; et
l'émetteur-récepteur est configuré pour transmettre le temps de passage du transpondeur et/ou la différence de temps au récepteur au temps de transmission souhaité.

8. Transpondeur (12) selon l'une quelconque des revendications 6 et 7 comprenant l'émetteur-récepteur (34) et l'unité de synchronisation de transmission (36), dans lequel
l'unité de synchronisation de transmission est configurée pour déterminer le temps de transmission souhaité sur la base d'un paramètre de récepteur d'un récepteur (20) à portée de l'émetteur-récepteur ; et
l'unité de synchronisation de transmission est de préférence configurée pour déterminer un temps de transmission ultérieur si le paramètre de récepteur indique que le récepteur ne peut pas communiquer via un réseau de données mobile.

9. Transpondeur (12) selon l'une quelconque des revendications 6 à 8 comprenant l'émetteur-récepteur (34) et l'unité de synchronisation de transmission (36), dans lequel
l'unité de synchronisation de transmission est configurée pour déterminer une différence de temps mise à jour si aucune confirmation de réception n'est obtenue du récepteur (20) après que le temps de passage du transpondeur et/ou la différence de temps a été transmis ; et
l'émetteur-récepteur est configuré pour transmettre la différence de temps mise à jour au récepteur.

10. Transpondeur (12) selon l'une quelconque des revendications précédentes, dans lequel les trois bobines inductives (26) sont disposées orthogonalement les unes aux autres dans trois directions orthogonales.

11. Système (14) pour déterminer un temps de passage d'un transpondeur (12), comprenant :
un transpondeur (12) selon l'une quelconque des revendications précédentes ;
une antenne boucle RFID (18) ; et
un récepteur (20) pour recevoir un temps de passage du transpondeur et/ou une différence de temps d'un transpondeur passant l'antenne boucle RFID, ledit récepteur correspondant en particulier à un émetteur-récepteur à courte distance étant agencé conjointement avec l'antenne boucle RFID dans un ensemble de chronométrage.

12. Système (14) selon la revendication 11, dans lequel le récepteur (20) est configuré pour déterminer un temps de passage absolu du transpondeur sur la base du temps de passage du transpondeur et/ou de la différence de temps et d'un temps absolu au moment de la réception du signal, en particulier en soustrayant la différence de temps du temps absolu.

13. Système (14) selon l'une quelconque des revendications 11 et 12, dans lequel le récepteur (20) est configuré pour déterminer le temps absolu sur la base d'un signal d'un récepteur GPS (24) et/ou sur la base d'une horloge interne de haute précision.

14. Procédé pour déterminer un temps de passage d'un transpondeur (12) lors du passage d'une antenne boucle RFID (18), le procédé étant mis en œuvre par un transpondeur selon l'une quelconque des revendications 1 à 10, comprenant les étapes :
mesure (S10) de trois valeurs d'intensité de champ d'un signal d'activation transmis par l'antenne boucle RFID lors du passage de l'antenne boucle RFID ;
détermination (S12) d'une valeur effective des trois valeurs d'intensité de champ indiquant une intensité de champ inductif sur la base des trois valeurs d'intensité de champ ;
collecte (S14) de valeurs effectives pour de multiples signaux d'activation au fil du temps et détermination d'une série temporelle de valeurs effectives ; **caractérisé en ce que** le procédé comprend l'étape de :
détermination (S16) d'un temps de passage du transpondeur correspondant à un moment dans le temps (P) au sein de la série temporelle auquel les valeurs effectives avant et après le moment dans le temps ont un niveau maximal de symétrie.

15. Programme informatique comprenant des moyens de code de programme pour amener un transpondeur selon l'une quelconque des revendications 1 à 10 à exécuter les étapes du procédé selon la revendication 14 lorsque ledit programme informatique est exécuté sur le transpondeur.
